Europäisches Patentamt

European Patent Office

Office européen des brevets

(19)

(11) Numéro de publication : **0 579 527 A1**

## (12) DEMANDE DE BREVET EUROPEEN

(21) Numéro de dépôt : **93401730.2**

(22) Date de dépôt : **02.07.93**

(51) Int. Cl.$^5$ : **G11C 11/41**

(30) Priorité : **10.07.92 FR 9208617**

(43) Date de publication de la demande :
**19.01.94 Bulletin 94/03**

(84) Etats contractants désignés :
**DE FR GB IT**

(71) Demandeur : **SGS-THOMSON MICROELECTRONICS S.A.**
**7, Avenue Galliéni**
**F-94250 Gentilly (FR)**

(72) Inventeur : **Carre, Laurent**
**H - Impasse L. Blériot**
**F-38340 Voreppe (FR)**
Inventeur : **Curtet, Joel**
**43A Quai du Drac**
**F-38600 Fontaine (FR)**

(74) Mandataire : **Schmit, Christian Norbert Marie et al**
**Cabinet Ballot-Schmit 7, rue Le Sueur**
**F-75116 Paris (FR)**

(54) **Procédé pour échanger des données numériques avec un opérateur asynchrone, registre numérique pour la mise en oeuvre de ce procédé, et unité de calcul comportant de tels registres.**

(57) Le registre numérique comprend, pour chaque bit des données numériques, un couple de bascules (2, 12) montées en parallèle. Chacune de ces bascules comporte respectivement une cellule de mémoire (3, 13), un moyen de chargement (4, 14) pour inscrire dans la cellule de mémoire (3, 13) une valeur du bit, et un moyen de lecture (5, 15) pour fournir la valeur du bit inscrite dans la cellule de mémoire (3, 13). Les moyens de chargement (4, 14) et les moyens de lecture (5, 15) des deux bascules (2, 12) sont activés et désactivés de façon cyclique à une même fréquence d'horloge. Les moyens de lecture respectifs (5, 15) des deux bascules (2, 12) sont activés de façon sensiblement alternée. Le moyen de lecture (5, 15) de chaque bascule (2, 12) est désactivé pendant que le moyen de chargement (4, 14) de cette bascule est activé.

Utilisation pour augmenter les cadences de calcul d'unités pilotées par une horloge de fréquence donnée.

FIG. 2

EP 0 579 527 A1

La présente invention concerne un procédé pour échanger des données numériques avec un opérateur asynchrone. L'invention vise également un registre numérique pour la mise en oeuvre de ce procédé, ainsi qu'une unité de calcul comportant de tels registres.

Un objectif principal de l'évolution des technologies utilisées dans les circuits intégrés est d'augmenter les vitesses de traitement. Ces circuits sont souvent pilotés par des horloges à quartz dont la fréquence est limitée en pratique. Aujourd'hui, piloter un circuit intégré avec un quartz de fréquence propre supérieure à 25 MHz n'est pas une solution réaliste pour des raisons de coût.

Cette fréquence d'horloge peut être le facteur limitant les performances du circuit en termes de cadence de traitement. Ainsi, le circuit peut comporter des opérateurs asynchrones, arithmétiques et/ou logiques, pouvant atteindre des cadences d'échange de données, en entrée et en sortie, supérieures à la fréquence de l'horloge à quartz utilisée pour les piloter. Les possibilités de ces opérateurs sont donc sous-exploitées.

Au vu de ce qui précède, le but de la présente invention est d'augmenter les cadences de traitement d'unités de calcul, arithmétiques et/ou logiques, comportant un ou plusieurs opérateurs asynchrones et pilotées par des signaux d'horloge de fréquence donnée ou, en d'autres termes, de proposer un procédé pour faire fonctionner une unité de calcul à une cadence donnée en utilisant une horloge de fréquence moindre.

Suivant l'invention, ce but est atteint par un procédé pour échanger des données numériques comportant au moins un bit avec un opérateur asynchrone au moyen d'un registre numérique, caractérisé en ce que ce registre numérique comprend, pour chaque bit, deux bascules montées en parallèle, chacune de ces deux bascules comportant respectivement une cellule de mémoire, un moyen de chargement pour inscrire dans la cellule de mémoire une valeur du bit, et un moyen de lecture pour fournir la valeur du bit inscrite dans la cellule de mémoire, en ce que les moyens de chargement et les moyens de lecture des deux bascules sont activés et désactivés de façon cyclique à une même fréquence d'horloge, en ce que les moyens de lecture respectifs des deux bascules sont activés de façon sensiblement alternée, et en ce que le moyen de lecture de chaque bascule est désactivé pendant que le moyen de chargement de cette bascule est activé.

L'agencement parallèle des bascules comportant les cellules de mémoire permet d'échanger des données numériques avec l'opérateur à une cadence qui est le double de la fréquence d'horloge. Au cours de chaque période de l'horloge, deux valeurs successives de chaque bit sont inscrites respectivement dans les deux cellules de mémoire montées en parallèle. Ces deux valeurs sont ensuite fournies à la sortie du registre avec un décalage temporel d'une demi-période et à une cadence égale au double de la fréquence d'horloge.

Un second aspect de l'invention vise un registre numérique pour la mise en oeuvre du procédé ci-dessus. Ce registre numérique, pour échanger des données numériques comportant au moins un bit avec un opérateur asynchrone, est caractérisé en ce qu'il comprend, pour chaque bit, deux bascules montées en parallèle, chacune de ces deux bascules comportant respectivement une cellule de mémoire, un moyen de chargement pour inscrire dans la cellule de mémoire une valeur du bit, et un moyen de lecture pour fournir la valeur du bit inscrite dans la cellule de mémoire, et en ce que les moyens de chargement et les moyens de lecture des deux bascules sont agencés pour être activés et désactivés de façon cyclique à une même fréquence d'horloge de façon telle que les moyens de lecture respectifs des deux bascules soient activés de façon sensiblement alternée et que le moyen de lecture de chaque bascule soit désactivé pendant que le moyen de chargement de cette bascule est activé.

Ce registre numérique peut être placé soit en entrée soit en sortie de l'opérateur asynchrone.

Le troisième aspect de l'invention vise une unité de calcul, comprenant un opérateur asynchrone, au moins un registre d'entrée, et un registre de sortie, caractérisée en ce que chaque registre d'entrée et le registre de sortie sont des registres numériques du type mentionné ci-dessus.

D'autres particularités et avantages de la présente invention apparaîtront dans la description ci-après d'exemples de réalisation préférés et non limitatifs, lue conjointement aux dessins annexés, dans lesquels :

- la figure 1 est un schéma d'une unité de calcul selon l'invention ;
- la figure 2 est un schéma d'un élément de registre numérique selon l'invention, faisant partie de l'unité de calcul de la figure 1 ;
- la figure 3 représente des chronogrammes illustrant le fonctionnement de l'unité de calcul de la figure 1 ;
- la figure 4 est un schéma d'une autre forme de réalisation de l'unité de calcul selon l'invention ; et
- la figure 5 représente des chronogrammes illustrant le fonctionnement de l'unité de calcul de la figure 4.

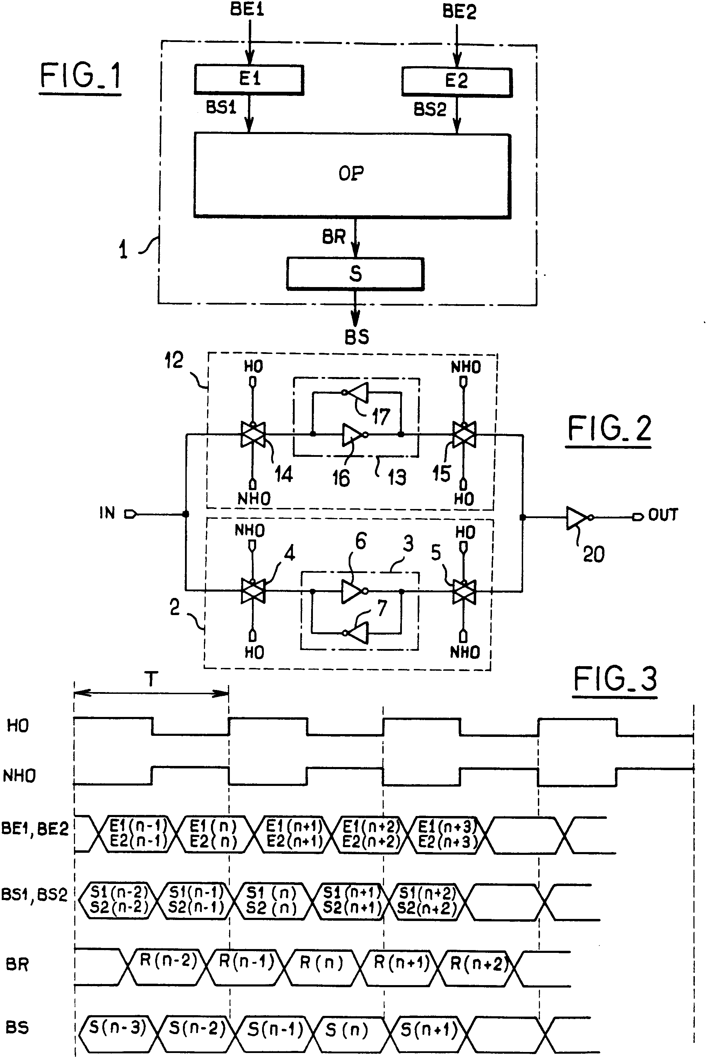

En référence à la figure 1, une unité de calcul 1 selon l'invention comprend un opérateur asynchrone OP. L'opérateur OP peut être un opérateur arithmétique et/ou logique. L'unité de calcul 1 est reliée avec l'extérieur par l'intermédiaire de deux bus d'entrée BE1, BE2, et d'un bus de sortie BS. Dans l'exemple représenté, l'unité de calcul 1 comprend deux registres d'entrée E1, E2 reliés respectivement aux bus d'entrée BE1, BE2, et alimentant l'opérateur OP par l'intermédiaire de deux bus BS1, BS2. L'unité de calcul 1 comprend en outre un registre de sortie S relié au bus de sortie BS, et recevant des données de l'opérateur OP par l'intermédiaire d'un bus BR.

L'opérateur OP reçoit deux opérandes par l'intermédiaire des registres d'entrée E1, E2, et délivre un résultat par l'intermédiaire du registre de sortie S. Les deux opérandes et le résultat sont des données numériques comportant chacun un certain nombre de bits. Chacun des registres E1, E2, S est constitué par un agencement parallèle d'éléments de registre du type représenté à la figure 2, un élément de registre correspondant à chaque bit.

En référence à la figure 2, chaque élément de registre selon l'invention comprend un couple de bascules 2, 12 montées en parallèle entre l'entrée IN et la sortie OUT de l'élément de registre. Chacune de ces deux bascules 2, 12 comporte respectivement une cellule de mémoire 3, 13, un moyen de chargement 4, 14 pour inscrire dans la cellule de mémoire 3, 13 une valeur du bit, et un moyen de lecture 5, 15 pour fournir la valeur du bit inscrite dans la cellule de mémoire 3, 13. Chacune des cellules de mémoire 3, 13 comporte, de façon connue, un inverseur 6, 16, et un inverseur résistif 7, 17 dont l'entrée est reliée à la sortie de l'inverseur 6, 16, et dont la sortie est reliée à l'entrée de l'inverseur 6, 16.

De façon connue, le moyen de chargement 4, 14 de chaque bascule 2, 12 est constitué par un interrupteur comprenant un transistor à effet de champ à canal N et un transistor à effet de champ à canal P dont le circuit source/drain est monté en parallèle avec celui du transistor à effet de champ à canal N. Le moyen de lecture 5, 15 de chaque bascule 2, 12 a une structure identique à celle du moyen de chargement 4, 14.

Comme les cellules de mémoire 3, 13 sont inverseuses, les deux bascules 2, 12 sont reliées à la sortie OUT de l'élément de registre par l'intermédiaire d'un inverseur 20.

Les moyens de chargement 4, 14 et les moyens de lecture 5, 15 des deux bascules 2, 12 sont activés et désactivés de façon cyclique à une même fréquence d'horloge F = 1/T. L'horloge à quartz (non représentée) délivre un signal d'horloge H0 de fréquence F et de rapport cyclique 0,5. Par l'intermédiaire d'une simple porte inverseuse, on peut obtenir un second signal d'horloge NH0, qui est le complémentaire du premier signal d'horloge H0. Le premier signal d'horloge H0 est adressé à la grille du transistor à effet de champ à canal N du moyen de chargement 4 de la première bascule 2, à la grille du transistor à effet de champ à canal P du moyen de lecture 5 de la première bascule 2, à la grille du transistor à effet de champ à canal P du moyen de chargement 14 de la seconde bascule 12, et à la grille du transistor à effet de champ à canal N du moyen de lecture 15 de la seconde bascule 12. Le signal d'horloge complémentaire NH0 est adressé à la grille du transistor à effet de champ à canal P du moyen de chargement 4 de la première bascule 2, à la grille du transistor à effet de champ à canal N du moyen de lecture 5 de la première bascule 2, à la grille du transistor à effet de champ à canal N du moyen de chargement 14 de la seconde bascule 12, et à la grille du transistor à effet de champ à canal P du moyen de lecture 15 de la seconde bascule 12. Ainsi, le moyen de chargement 4 de la première bascule 2 et le moyen de lecture 15 de la seconde bascule 12 sont activés lorsque le premier signal d'horloge H0 est à l'état haut. Le moyen de lecture 5 de la première bascule 2 et le moyen de chargement 14 de la seconde bascule 12 sont activés lorsque le second signal d'horloge NH0 est à l'état haut.

Comme les signaux d'horloge H0, NH0 sont complémentaires l'un de l'autre, les moyens de lecture respectifs 5, 15 des deux bascules 2, 12 sont activés de façon alternée, et le moyen de lecture 5, 15 de chaque bascule 2, 12 est désactivé pendant que le moyen de chargement 4, 14 de cette bascule est activé.

Les chronogrammes de la figure 3 illustrent le fonctionnement de l'unité de calcul 1 de la figure 1 lorsque les opérandes sont fournis sur les bus d'entrée BE1, BE2 à une cadence égale au double de la fréquence d'horloge F. Les deux premières lignes de la figure 3 représentent les signaux d'horloge complémentaires H0, NH0, et la troisième ligne représente les valeurs E1(i), E2(i) des opérandes reçues successivement sur les bus d'entrée BE1, BE2. A chaque front descendant du signal d'horloge H0, les valeurs des opérandes sont mémorisées pour une demi-période T/2 dans les cellules de mémoire 3 des premières bascules 2. Pendant cette demi-période (H0 à l'état bas, NH0 à l'état haut), les moyens de lecture 5 des premières bascules 2 sont activés, de sorte que ces valeurs S1(i), S2(i) des opérandes sont fournies à l'opérateur 0P par l'intermédiaire des bus BS1, BS2. A la fin de cette demi-période (front montant du signal H0), les valeurs des opérandes sont mémorisées pour la demi-période suivante dans les cellules de mémoire 13 des secondes bascules 12. Pendant la demi-période suivante, les moyens de lecture 15 des secondes bascules 12 sont activés (H0 à l'état haut, NH0 à l'état bas), et les valeurs des opérandes sont fournies à l'opérateur OP par l'intermédiaire des bus BS1, BS2. Les valeurs S1(i), S2(i) des opérandes sont donc fournies sur les bus BS1 BS2 comme l'indique la quatrième ligne de la figure 3. Avec un certain retard inférieur à une demi-période, l'opérateur OP délivre les résultats R(i) sur le bus BR, comme l'indique la cinquième ligne de la figure 3. Ces résultats sont ensuite adressés au bus de sortie BS (dernière ligne de la figure 3) après être passés par le registre de sortie S qui fonctionne comme les registres d'entrée E1, E2.

L'invention permet donc de faire fonctionner l'opérateur OP avec des cadences d'échange de données en entrée et en sortie égales au double de la fréquence d'horloge F. On peut ainsi, pour un opérateur ayant une cadence de traitement donnée, utiliser comme horloge un quartz dont la fréquence propre est égale à la moitié de cette cadence.

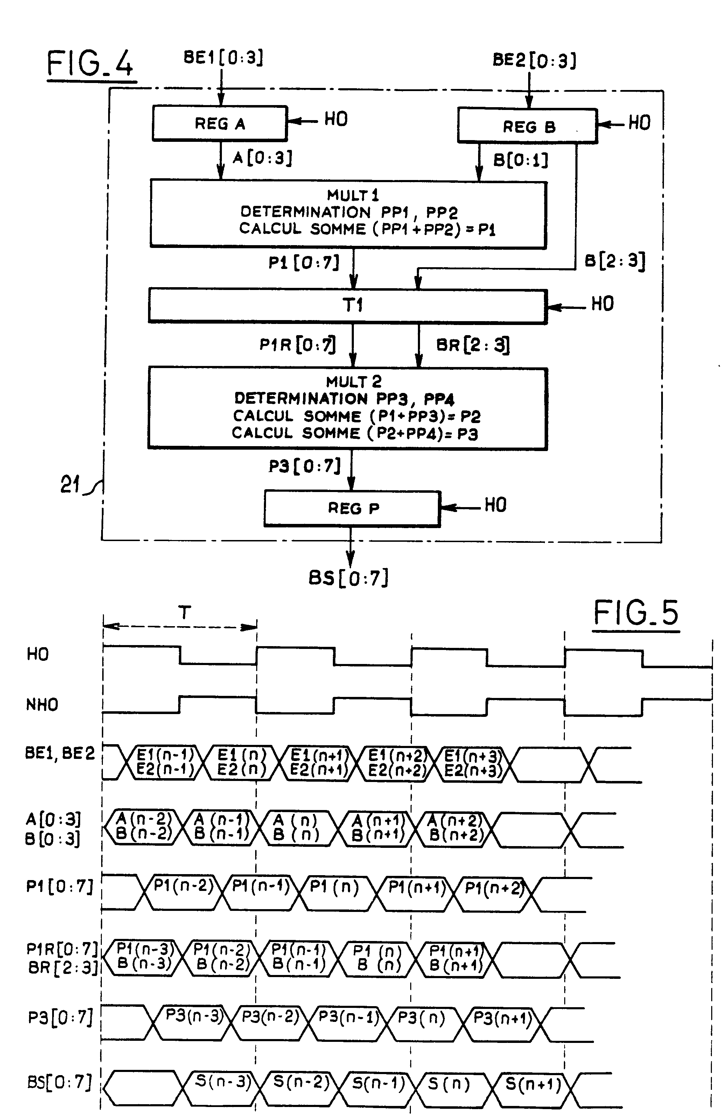

Un autre exemple de réalisation de l'invention est illustré à la figure 4. Dans cet exemple, l'unité de calcul 21 comprend un opérateur de multiplication 4x4 non signé qui, toutes les demi-périodes d'horloge, doit multiplier deux opérandes A, B comportant chacun quatre bits pour former un produit P = A x B comportant huit bits. Cette multiplication s'écrit :

$$
\begin{array}{cccc}
A3 & A2 & A1 & A0 \\
x \ \ B3 & B2 & B1 & B0 \\
\hline
\end{array}
$$

$$P8 \ \ P7 \ \ P6 \ \ P5 \ \ P4 \ \ P3 \ \ P2 \ \ P1 \ \ P0,$$

où les Ai, Bi, Pi désignent respectivement les valeurs des bits des opérandes A, B et du produit P. Pour réaliser cette multiplication, on doit déterminer quatre produits partiels :

$$
\begin{array}{lcccccccccl}
PP1 & = & 0 & 0 & 0 & 0 & A3 & A2 & A1 & A0 & \quad si \ B0 = 1, \\
    &   & 0 & 0 & 0 & 0 & 0 & 0 & 0 & 0 & \quad si \ B0 = 0, \\
\\
PP2 & = & 0 & 0 & 0 & A3 & A2 & A1 & A0 & 0 & \quad si \ B1 = 1, \\
    &   & 0 & 0 & 0 & 0 & 0 & 0 & 0 & 0 & \quad si \ B1 = 0, \\
\\
PP3 & = & 0 & 0 & A3 & A2 & A1 & A0 & 0 & 0 & \quad si \ B2 = 1, \\
    &   & 0 & 0 & 0 & 0 & 0 & 0 & 0 & 0 & \quad si \ B2 = 0, \\
\\
PP4 & = & 0 & A3 & A2 & A1 & A0 & 0 & 0 & 0 & \quad si \ B3 = 1, \\
    &   & 0 & 0 & 0 & 0 & 0 & 0 & 0 & 0 & \quad si \ B3 = 0. \\
\end{array}
$$

et les additionner :
$$P = A \ x \ B = PP4 + (PP3 + (PP2 + PP1)).$$

Si le temps nécessaire pour réaliser ces trois additions est supérieur à une demi-période d'horloge T/2, on peut scinder le multiplieur en deux modules asynchrones montés en cascade et réaliser une opération à chevauchement d'instructions, ou "pipelinée" (détermination de PP1, PP2 et calcul de P1 = PP1 + PP2 pendant une demi-période ; détermination de PP3, PP4 et calcul de P3 = (P1 + PP3) + PP4 pendant la demi-période suivante).

On utilise alors une unité de calcul telle que celle représentée à la figure 4. Les opérandes A, B sont adressés à l'unité de calcul 21 par l'intermédiaire des bus d'entrée BE1 [0:3], BE2 [0:3] comportant chacun quatre conducteurs. Le produit P est fourni par l'unité de calcul 21 sur le bus de sortie BS [0:7] ayant huit conducteurs. Les registres d'entrée REG A, REG B pour le stockage des opérandes A, B sont constitués chacun par quatre couples de bascules parallèles du type représenté à la figure 2. Les quatre bits de l'opérande A sont adressés au premier module MULT1 par un bus à quatre conducteurs A [0:3], et les deux bits de poids faible de l'opérande B sont adressés au module MULT1 par le bus à deux conducteurs B [0:1]. Le premier module MULT1 calcule les produits partiels PP1 et PP2, ainsi que la somme (PP1 + PP2) = P1. Cette somme P1, codée sur huit bits, est délivrée par le module MULT1 sur le bus à huit conducteurs P1 [0:7].

Entre les deux modules successifs montés en cascade MULT1, MULT2, est disposé un registre tampon T1. Ce registre tampon T1 est un registre numérique constitué de dix (= 8 + 2) couples de bascules parallèles du type représenté à la figure 2. Les huit premiers couples de bascules parallèles du registre T1 servent au stockage temporaire des huit bits de la somme partielle P1 fournie par le premier module MULT1, et les deux derniers couples de bascules parallèles du registre T1 servent au stockage temporaire des deux bits de poids fort de l'opérande B, qui lui sont adressés par le bus à deux conducteurs B [2:3] relié au registre d'entrée REG B (les deux bits de poids fort de l'opérande B sont nécessaires seulement pour calculer les produits partiels PP3, PP4). Les valeurs des bits stockés dans le registre tampon T1 sont fournies au second module MULT2 par l'intermédiaire d'un bus à huit conducteurs P1R [0:7] et d'un bus à deux conducteurs BR [2:3]. Le second module MULT2 calcule les produits partiels PP3, PP4 puis les sommes P2 = (P1 + PP3) et P3 = (P2 + PP4). Le nombre P3 codé sur huit bits correspond au produit des deux opérandes A, B. Ce produit est adressé au registre de sortie REG P par l'intermédiaire d'un bus à huit conducteurs P3 [0:7].

Les registres d'entrée REG A, REG B, le registre tampon T1, et le registre de sortie REG P sont tous constitués par des couples de bascule parallèle du type représenté à la figure 2 et sont tous activés par les mêmes signaux d'horloge H0.

L'unité de calcul 21 permet de calculer les produits des opérandes A, B à une cadence égale au double de la fréquence d'horloge F des signaux H0. On réalise ainsi un multiplieur pouvant atteindre, par exemple, une cadence de 40 MHz avec une fréquence d'horloge de 20 MHz (il n'existe pas actuellement de quartz oscillant à 40 MHz).

Les valeurs présentes sur les différents bus de l'unité de calcul 21 sont représentées sur les chronogrammes de la figure 5. A un instant donné, le module MULT1 calcule la somme partielle P1 avec les opérandes i, alors que le module MULT2 calcule le produit global P3 des opérandes i - 1. Pour calculer le produit de deux valeurs données des opérandes A, B, il y a un décalage d'une demi-période T/2 entre le calcul de la somme partielle P1 (module MULT1) et le calcul définitif du produit global P3 (module MULT2). Ce retard est assuré par le registre tampon T1.

Bien qu'on ait décrit l'invention en référence à des exemples de réalisation préférés, on comprendra que ces exemples ne sont pas limitatifs et que diverses modifications peuvent leur être apportées sans sortir du cadre de l'invention.

Ainsi, la forme de réalisation de l'invention illustrée à la figure 4 peut être généralisée à un circuit multiplieur Nbits x Mbits avec un nombre quelconque de modules montés en cascade, un registre tampon conforme à l'invention étant disposé entre chaque paire de modules successifs montés en cascade.

L'invention peut également être appliquée à une unité arithmétique autre qu'un multiplieur, ou à une unité logique.

## Revendications

1. Procédé pour échanger des données numériques comportant au moins un bit avec un opérateur asynchrone (OP ; MULT1, MULT2) au moyen d'un registre numérique (E1, E2, S ; REG A, REG B, T1, REG P), caractérisé en ce que ce registre numérique comprend, pour chaque bit, un couple de bascules (2, 12) montées en parallèle, chacune de ces bascules comportant respectivement une cellule de mémoire (3, 13), un moyen de chargement (4, 14) pour inscrire dans la cellule de mémoire (3, 13) une valeur du bit, et un moyen de lecture (5, 15) pour fournir la valeur du bit inscrite dans la cellule de mémoire (3, 13), en ce que les moyens de chargement (4, 14) et les moyens de lecture (5, 15) des deux bascules (2, 12) sont activés et désactivés de façon cyclique à une même fréquence d'horloge (F), en ce que les moyens de lecture respectifs (5, 15) des deux bascules (2, 12) sont activés de façon sensiblement alternée, et en ce que le moyen de lecture (5, 15) de chaque bascule (2, 12) est désactivé pendant que le moyen de chargement (4, 14) de cette bascule est activé.

2. Procédé conforme à la revendication 1, caractérisé en ce que, pour chaque bit, les moyens de chargement (4, 14) respectifs des deux bascules (2, 12) sont activés de façon sensiblement alternée.

3. Procédé conforme à la revendication 2, caractérisé en ce que, pour chaque bit, le moyen de chargement (4) de la première bascule (2) et le moyen de lecture (15) de la seconde bascule (12) sont activés lorsqu'un premier signal d'horloge (H0) est à l'état haut, et le moyen de lecture (5) de la première bascule (2) et le moyen de chargement (14) de la seconde bascule (12) sont activés lorsqu'un second signal d'horloge (NHO), qui est complémentaire du premier signal d'horloge (HO), est à l'état haut.

4. Registre numérique (E1, E2, S ; REG A, REG B, T1, REG P) pour échanger des données numériques comportant au moins un bit avec un opérateur asynchrone (OP ; MULT1, MULT2), caractérisé en ce qu'il comprend, pour chaque bit, un couple de bascules (2, 12) montées en parallèle, chacune de ces bascules comportant respectivement une cellule de mémoire (3, 13), un moyen de chargement (4, 14) pour inscrire dans la cellule de mémoire (3, 13) une valeur du bit, et un moyen de lecture (5, 15) pour fournir la valeur du bit inscrite dans la cellule de mémoire (3, 13), et en ce que les moyens de chargement (4, 14) et les moyens de lecture (5, 15) des deux bascules (2, 12) sont agencés pour être activés et désactivés de façon cyclique à une même fréquence d'horloge (F) de façon telle que les moyens de lecture respectifs (5, 15) des deux bascules soient activés de façon sensiblement alternée et que le moyen de lecture (5, 15) de chaque bascule (2, 12) soit désactivé pendant que le moyen de chargement (4, 14) de cette bascule est activé.

5. Registre numérique conforme à la revendication 4, caractérisé en ce que, pour chaque bit, les moyens de chargement (4, 14) respectifs des deux bascules (2, 12) sont agencés pour être activés de façon sensiblement alternée.

6. Registre numérique conforme à la revendication 5, caractérisé en ce que pour chaque bit, le moyen de chargement (4) de la première bascule (2) et le moyen de lecture (15) de la seconde bascule (12) sont activés lorsqu'un premier signal d'horloge (H0) est à l'état haut, et le moyen de lecture (5) de la première bascule (2) et le moyen de chargement (14) de la seconde bascule (12) sont activés lorsqu'un second signal d'horloge (NHO), qui est complémentaire du premier signal d'horloge (HO), est à l'état haut.

7. Unité de calcul (1 ; 21), comprenant un opérateur asynchrone (OP ; MULT1, MULT2), au moins un registre d'entrée (E1, E2 ; REG A, REG B), et un registre de sortie (S ; REG P), caractérisée en ce que chaque registre d'entrée et le registre de sortie sont des registres numériques conformes à l'une des revendications 4 à 6.

8. Unité de calcul (21) conforme à la revendication 7, dans lequel l'opérateur comporte plusieurs modules asynchrones (MULT1, MULT2) montés en cascade, caractérisée en ce qu'un registre numérique (T1) conforme à l'une des revendications 4 à 6 est disposé entre chaque paire de modules successifs montés en cascade.

FIG_1

FIG_2

FIG_3

7

## FIG_4

BE1[0:3]    BE2[0:3]

REG A  ← HO

REG B  ← HO

A[0:3]    B[0:1]

MULT 1
DETERMINATION PP1, PP2
CALCUL SOMME (PP1+PP2) = P1

P1[0:7]    B[2:3]

T1  ← HO

P1R[0:7]    BR[2:3]

MULT 2
DETERMINATION PP3, PP4
CALCUL SOMME (P1+PP3)= P2
CALCUL SOMME (P2+PP4)= P3

P3[0:7]

21

REG P  ← HO

BS[0:7]

## FIG_5

HO

NHO

BE1, BE2 : E1(n-1)/E2(n-1) | E1(n)/E2(n) | E1(n+1)/E2(n+1) | E1(n+2)/E2(n+2) | E1(n+3)/E2(n+3)

A[0:3] / B[0:3] : A(n-2)/B(n-2) | A(n-1)/B(n-1) | A(n)/B(n) | A(n+1)/B(n+1) | A(n+2)/B(n+2)

P1[0:7] : P1(n-2) | P1(n-1) | P1(n) | P1(n+1) | P1(n+2)

P1R[0:7] / BR[2:3] : P1(n-3)/B(n-3) | P1(n-2)/B(n-2) | P1(n-1)/B(n-1) | P1(n)/B(n) | P1(n+1)/B(n+1)

P3[0:7] : P3(n-3) | P3(n-2) | P3(n-1) | P3(n) | P3(n+1)

BS[0:7] : S(n-3) | S(n-2) | S(n-1) | S(n) | S(n+1)

**Office européen**

**des brevets**

## RAPPORT DE RECHERCHE EUROPEENNE

Numero de la demande

EP 93 40 1730

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| Y | SYMPOSIUM ON VLSI CIRCUITS 7 Juin 1990 , HONOLULU pages 107 - 108 XP000145629 MATSUMURA ET AL 'Pipelined, Time-Sharing Access Technique for a Highly Integrated Multi-Port Memory' | 1,2,4-8 | G11C11/41 |
| A | * le document en entier * | 3 | |
| Y | COMMUNICATIONS OF THE ASSOCIATION FOR COMPUTING MACHINERY vol. 32, no. 6 , Juin 1989 , NEW YORK US pages 720 - 738 XP000256681 SUTHERLAND 'Micropipelines' * page 726, colonne de droite, ligne 26 - page 728, colonne de gauche, ligne 29; figures 11,12,17 * * page 730, colonne de gauche, ligne 17 - colonne de droite, ligne 1 * | 1,2,4-8 | |
| A | PATENT ABSTRACTS OF JAPAN vol. 1, no. 160 (E-076)19 Décembre 1977 & JP-A-52 105 737 (NIPPON SHINGO) 5 Septembre 1977 * abrégé * | 3 | |
| A | PATENT ABSTRACTS OF JAPAN vol. 9, no. 221 (P-386)7 Septembre 1985 & JP-A-60 079 453 (MITSUBISHI DENKI) 7 Mai 1985 * abrégé * | 3 | |

**DOMAINES TECHNIQUES RECHERCHES (Int.Cl.5)**

G11C

Le présent rapport a été établi pour toutes les revendications

| Lieu de la recherche | Date d'achèvement de la recherche | Examinateur |
|---|---|---|
| LA HAYE | 21 Octobre 1993 | CARDUS, A |

EPO FORM 1503 03.82 (P04C02)